# EUROPEAN PATENT APPLICATION

(11) **EP 4 443 179 A1**
(43) Date of publication of application: **09.10.2024**
(21) Application number: 24168570.0
(22) Date of filing: 04.04.2024
(51) Int. Cl.: G01R 31/327, G01R 31/54, H01M 10/48, H01M 50/543, G01R 1/36

(54) **BATTERY SYSTEM AND DIAGNOSIS METHOD OF HIGH-SIDE DRIVER USING THE SAME**

(30) Priority: 05.04.2023 KR 20230044905
(71) Applicant: Samsung SDI Co., Ltd., Yongin-si, Gyeonggi-do 17084 (KR)
(72) Inventor: SEO, Giho, 17084 Yongin-si (KR); KIM, Duck-Hyun, 446-902 Yongin-si (KR); YOO, Kwangmin, 17084 Yongin-si (KR); KOO, Kyosung, 17084 Yongin-si (KR)
(74) Representative: Marks & Clerk LLP

(57) **Abstract**

A battery system includes a battery pack; a plurality of relays that are connected to the battery pack; a relay driver that commonly drives a low side of the plurality of relays and drives each of the plurality of relays at a high side of each of the plurality of relays; and a battery management system that controls an operation of the relay driver, receives a voltage measured from one terminal of each of the plurality of relays, and diagnoses the relay driver based on the received voltage.

## Description

### BACKGROUND

### 1. Field

The present disclosure relates to a battery system and a diagnosis method of a high-side driver using the same.

### 2. Description of Related Art

In general, a mechanical relay may be used for opening and closing an output of a high voltage battery in a battery pack. The mechanical relay may be composed of a coil terminal and a large current terminal, and when a current greater than or equal to a pickup current flows to the coil terminal, a magnetic force may be generated to connect both terminals of the large current terminal so that a current flows. In order to flow sufficient excitation current to a coil, the coil terminal may include large inductive reactance and low resistance, and the large current terminal may include very small resistance to reduce power consumption and heat generation.

A driver driving the relay may include a plurality of high-side drivers (HSD) driving a plurality of high side switches between a plurality of relays and a relay driving power supply and a low-side driver (LSD) driving a low side switch between the relays and a ground. Various failures may occur in the HSD, the LSD, the relay, the battery, or the like.

### SUMMARY

A battery system according to embodiments includes a battery pack; a plurality of relays that are connected to the battery pack; a relay driver that commonly drives a low side of the plurality of relays and drives each of the plurality of relays at a high side of each of the plurality of relays; and a battery management system (BMS) that controls an operation of the relay driver, receives a voltage measured from one terminal of each of the plurality of relays, and diagnoses the relay driver based on the received voltage.

The relay driver may include a high-side driver (HSD) supplying a relay driving voltage to a high side of a relay corresponding to a first signal among the plurality of relays based on the first signal received from the battery management system; a low-side driver (LSD) connecting the low side of the plurality of relays to a ground based on a second signal received from the battery management system; and a plurality of current sink circuits sinking a current from a node between the high-side driver and a high side of a relay corresponding to a third signal among the plurality of relays based on the third signal received from the battery management system.

The high-side driver may include a plurality of switches connected between the relay driving voltage and the plurality of relays, and each of the plurality of switches may receive a control signal from a pin.

The battery system may further include a plurality of voltage sensors transmitting voltage measurement signals generated by measuring voltages from high sides of the plurality of relays to the battery management system.

The battery management system may supply the relay driving voltage to one relay of the plurality of relays, may drive the plurality of current sink circuits, and may receive the voltage measurement signals from the plurality of voltage sensors.

The battery management system may derive a voltage of a high side of the one relay and a voltage of a high side of each of the remaining at least one relay other than the one relay among the plurality of relays based on the voltage measurement signals, and may determine that a short between high side pins connected to a relay among the remaining at least one relay having a voltage of a high side equal to the voltage of the high side of the one relay occurs.

A diagnosis method according to embodiments includes commonly driving, by a relay driver, a low side of a plurality of relays connected to a battery pack and driving, by a relay driver, each of the plurality of relays at a high side of each of the plurality of relays; measuring a voltage from one terminal of each of the plurality of relays; and diagnosing the relay driver based on the measured voltage.

The driving of each of the plurality of relays may include supplying, by a high-side driver (HSD), a relay driving voltage to a high side of a relay corresponding to a first signal among the plurality of relays based on the first signal received from a battery management system (BMS); connecting, by a low-side driver (LSD), the low side of the plurality of relays to a ground based on a second signal received from the battery management system; and sinking, by a plurality of current sink circuits, a current from a node between the high-side driver and a high side of a relay corresponding to a third signal among the plurality of relays based on the third signal received from the battery management system.

The supplying of the relay driving voltage to the high side of the relay may include applying, by the battery management system, control signals to a plurality of switches connected between the relay driving voltage and the plurality of relays through a plurality of pins of the high-side driver (HSD) to turning on the plurality of switches.

The measuring of the voltage from the one terminal of each of the plurality of relays may include generating voltage measurement signals by measuring voltages from high sides of the plurality of relays; and transmitting the generated voltage measurement signals to the battery management system.

The diagnosis method may further include generating, by the battery management system, a signal supplying the relay driving voltage to one relay of the plurality of relays to transmit the generated signal to the high-side driver; generating, by the battery management system, a signal driving the plurality of current sink circuits to transmit the generated signal to the current sink circuits; and receiving, by the battery management system, a voltage measurement signal representing a voltage measured from the high side of each of the plurality of relays.

The diagnosis method may further include deriving a voltage of a high side of the one relay and a voltage of a high side of each of the remaining at least one relay other than the one relay among the plurality of relays based on the voltage measurement signal; and determining that a short between high side pins connected to a relay among the remaining at least one relay having a voltage of a high side equal to the voltage of the high side of the one relay occurs.

At least some of the above and other features of the invention are set out in the claims. Embodiments of the invention may provide a battery system and a diagnosis method of a high-side driver capable of detecting (or sensing) a short between a plurality of open pins (hereinafter, a short between pins or a short circuit between pins) for applying signals for driving a plurality of high-side switches.

Accordingly, it is possible to detect occurrence of a short between pins while a low side of a relay is commonly operated and a high side of the relay is independently operated. Accordingly, through common operation of low side of the relay, complex interfaces may be simplified, costs may be reduced, and a failure of a high side driver (HSD) may be diagnosed. Further, according to the present disclosure, it is possible to improve an Automotive Safety Integrity Level (ASIL) level according to reduction of Failures in Time (FIT) by expanding a diagnosis region of a battery system.

### BRIEF DESCRIPTION OF THE DRAWINGS

Features will become apparent to those of skill in the art by describing in detail exemplary embodiments with reference to the attached drawings, in which:
FIG. 1 is a block diagram schematically showing a battery system according to embodiments.
FIG. 2 is a block diagram schematically illustrating a detailed configuration of the battery system of FIG. 1.
FIG. 3 is a flowchart of a diagnosis method of a high-side driver (HSD) using the battery system according to embodiments.
FIG. 4 is a circuit diagram of a relay (or a relay portion) and a relay driver of the battery system according to embodiments.
FIG. 5 is an exemplary diagram of a comparative circuit excluding the current sink circuits from the circuit diagram of FIG. 4.
FIG. 6 is an exemplary diagram of two-channel relay and a two-channel relay driver.
FIG. 7 is a waveform diagram of a voltage monitored through the circuit of FIG. 6.

### DETAILED DESCRIPTION

Hereinafter, embodiments disclosed in the present specification will be described in detail with reference to the accompanying drawings, and in the present specification, the same or similar constituent elements will be denoted by the same or similar reference numerals, and a redundant description thereof will be omitted. The terms "module" and/or "unit, portion, or part" representing constituent element used in the following description are used only in order to make understanding of the specification easier, and thus, these terms do not have meanings or roles that distinguish them from each other by themselves. In addition, in describing embodiments of the present specification, when it is determined that a detailed description of the well-known art associated with the present disclosure may obscure the gist of the present disclosure, it will be omitted. Further, the accompanying drawings are provided only in order to allow embodiments disclosed in the present specification to be easily understood and are not to be interpreted as limiting the disclosure of the present specification, and it is to be understood that the present disclosure includes all modifications, equivalents, and substitutions without departing from the scope of the present disclosure.

Terms including ordinal numbers such as first, second, and the like will be used only to describe various constituent elements, and are not to be interpreted as limiting these constituent elements. The terms are only used to differentiate one constituent element from other constituent elements.

In the present application, it should be understood that the term "include", "comprise", "have", or "configure" indicates that a feature, a number, a step, an operation, a constituent element, a part, or a combination thereof described in the specification is present, but does not exclude a possibility of presence or addition of one or more other features, numbers, steps, operations, constituent elements, parts, or combinations, in advance.

From among configurations according to an embodiment, a program that is realized with a set of instructions that are an actualized control algorithm for controlling other configurations may be installed in the configuration for controlling the other configurations in a specific control condition. A control configuration may process input data and stored data according to the installed program and may generate output data. The control configuration may include a non-volatile memory for storing a program and a memory for storing data.

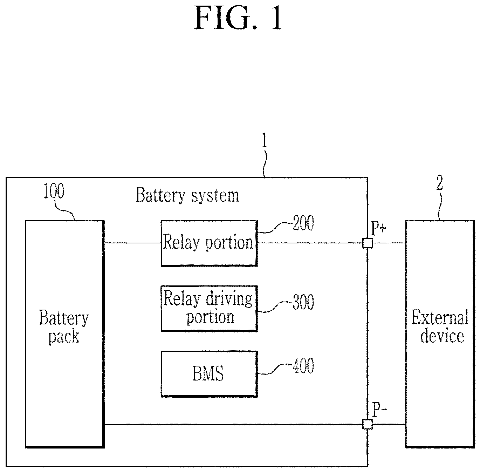

FIG. 1 is a block diagram schematically showing a battery system according to embodiments.

The battery system 1 may include a battery pack 100, a relay portion 200 (e.g., a relay unit), a relay driver 300 (e.g., a relay driving unit or portion), and a battery management system (BMS) 400.

An external device 2 may include a load, e.g., an inverter, a converter, or the like, and/or a charging device. For example, both terminals P+ and P- of the battery system 1 may be connected to a charger so that the battery system 1 is charged by receiving electric power from the charger. In some embodiments, both terminals P+ and P- of the battery system 1 may be connected to the load so that power supplied by the battery pack 100 is discharged through the load. The battery pack 100 may include a plurality of battery cells connected in series and/or in parallel.

The relay portion 200 includes a plurality of relays connected to the battery pack 100. One terminal of the relay portion 200 may be connected to the battery pack 100, and the other terminal of the relay portion 200 may be connected to one of both terminals of the battery system 1. For example, as illustrated in FIG. 1, the relay portion 200 may be connected only to one terminal of the battery pack 100 and one terminal P+ of the battery system 1. The relay portion 200 may include at least one first relay connected between one terminal (e.g., a positive terminal) of the battery pack 100 and one terminal P+ of the battery system 1 and at least one second relay connected between the other terminal (e.g., a negative terminal) of the battery pack 100 and the other terminal P- of the battery system 1. Hereinafter, the number of relays included in the relay portion 200 will be described as a plurality of relays.

The relay driver 300 drives the relay portion 200 under a control of the BMS 400. The relay driver 300 may include a plurality of high-side drivers (HSD) and a low-side driver (LSD).

The HSD may drive high side switches, in the relay driver 300, between the plurality of relays and a relay driving voltage for driving the relays. The LSD may drive a low side switch between the plurality of relays and a ground.

The relay driver 300 can drive each of the plurality of relays included in the relay portion 200 at a high side of each of the plurality of relays while driving a low side of the relay portion 200 in common. The relay driver 300 may include a current sink circuit in each high side channel of the relay portion 200 so that each high side channel independently diagnoses the plurality of HSD. The relay driver 300 may operate a current sink circuit corresponding to the remaining relay except for one relay to be monitored among the plurality of relays so that each high side channel independently diagnoses the plurality of HSD.

The BMS 400 controls an operation of the relay driver 300. The BMS 400 may control the operation of the relay driver 300 through the plurality of HSD, the LSD, a plurality of current sink circuits, and the like, and can diagnose the relay driver 300 based on a voltage and/or a current measured from the relay portion 200 and/or the relay driver 300. For example, a voltage sensor may measure a voltage from one terminal of each of the plurality of relays included in the relay portion 200, a current sensor may measure a current from a wire included in the relay driver 300, and the BMS 400 may receive the measured value from the voltage sensor and/or the current sensor. The BMS 400 may diagnose the relay driver 300 based on the voltage and/or the current received from the voltage sensor and/or the current sensor. Diagnosing the relay driver 300 by the BMS 400 may include diagnosing states of the plurality of HSD included in the relay driver 300. Diagnosing the relay driver 300 may include receiving or generating a value or signal based on which a fault in an HSD can be determined. For example, by means of a comparison with a threshold or expected value or signal. For example, comparing a voltage of one of the plurality of HSD with the voltage of another one of the plurality of HSD.

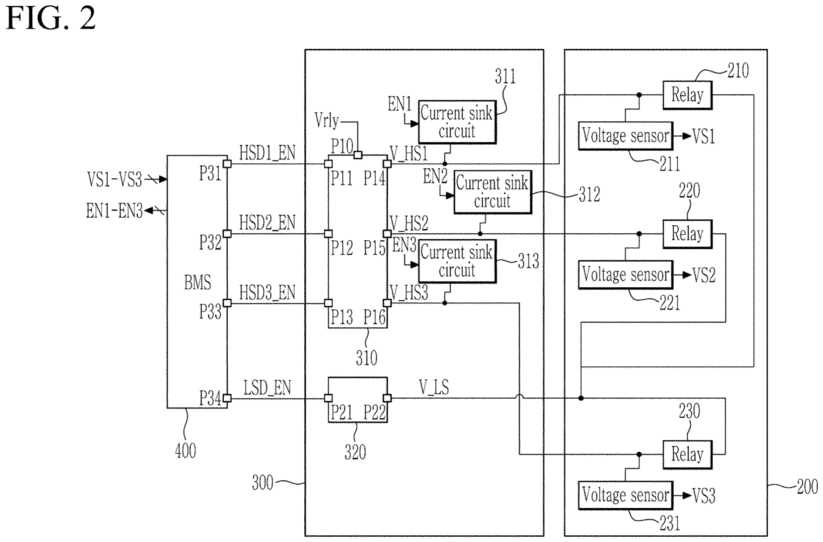

Hereinafter, a detailed configuration of the battery system 1 will be described with reference to FIG. 2. FIG. 2 is a block diagram schematically illustrating the detailed configuration of the battery system of FIG. 1.

The relay portion 200 may include a plurality of relays 210, 220, and 230 and a plurality of voltage sensors 211, 221, and 231. The relay driver 300 may include an HSD 310, an LSD 320, and a plurality of current sink circuits 311, 312, and 313.

The HSD 310 may include a plurality of terminals P10-P16. Each of the plurality of terminals P10-P16 may correspond to a pin of the HSD 310.

The HSD 310 may receive a relay driving voltage Vrly through the terminal P10. For example, the relay driving voltage Vrly may be an auxiliary voltage of a vehicle.

The BMS 400 may apply a plurality of driver enable signals HSD1_EN, HSD2_EN, and HSD3_EN to the HSD 310 through a plurality of terminals P31-P33, and may apply a driver enable signal LSD_EN to the LSD 320 through a terminal P34.

The HSD 310 may receive the plurality of driver enable signals HSD 1 EN, HSD2_EN, and HSD3_EN from the BMS 400 through a plurality of terminals P11-P13.

The HSD 310 may generate a plurality of relay coil voltages V_HS1-V_HS3 according to the plurality of driver enable signals HSD1_EN, HSD2_EN, and HSD3_EN, and may transmit the plurality of relay coil voltages V_HS1-V_HS3 to terminals of the plurality of relays 210, 220, and 230 through a plurality of terminals P14-P16.

For example, the HSD 310 receiving the driver enable signal HSD1_EN of an on-level through the terminal P11 may generate the relay coil voltage V_HS1 of an on-level to transmit the relay coil voltage V_HS1 of the on-level to one terminal of the relay 210 through the terminal P14. The HSD 310 receiving the driver enable signal HSD2_EN of an on-level through the terminal P12 may generate the relay coil voltage V_HS2 of an on-level to transmit the relay coil voltage V_HS2 of the on-level to one terminal of the relay 220 through the terminal P15. The HSD 310 receiving the driver enable signal HSD3_EN of an on-level through the terminal P13 may generate the relay coil voltage V_HS3 of an on-level to transmit the relay coil voltage V_HS3 of the on-level to one terminal of the relay 230 through the terminal P16.

The relay (e.g., 210) that receives the relay coil voltage (e.g., V_HS1) of the on-level among the plurality of relays 210, 220, and 230 may be turned on by a magnetic field caused by a current flowing to a coil of the relay.

The plurality of current sink circuits 311-313 may be connected to the plurality of terminals P14-P16. The BMS 400 may transmit a plurality of enable signals EN1-EN3 to the plurality of current sink circuits 311-313. The BMS 400 may control driving of the plurality of current sink circuits 311-313 through the plurality of enable signals EN1-EN3.

The plurality of current sink circuits 311-313 may sink a current from a node between the HSD 310 and the plurality of relays 210, 220, and 230 based on the plurality of enable signals EN1-EN3. Hereinafter, a current sink operation in which the current sink circuit sinks the current may refer to an operation of flowing a current from a predetermined node to a ground.

The current sink circuit (e.g., 311) receiving the enable signal (e.g., EN1) of an on-level among the plurality of current sink circuits 311-313 may flow a constant current to the ground.

For example, as illustrated in FIG. 2, the BMS 400 may generate the plurality of enable signals EN1-EN3 that control driving of the plurality of current sink circuits 311-313. In another example, the plurality of enable signals EN1-EN3 may be generated using electric power supplied from the battery pack 100 of FIG. 1. In this case, the plurality of enable signals EN1-EN3 may be always activated. For convenience of description, it is assumed that the enable signal applied to the HSD 310, the LSD 320, and the plurality of current sink circuits 311-313 is generated and transmitted by the BMS 400.

For example, as illustrated in FIG. 2, the number of the plurality of relays 210, 220, and 230 and the number of the plurality of current sink circuits 311-313 may be three. The battery system 1 may include two or more relays and current sink circuits corresponding to the relays.

The LSD 320 may include a plurality of terminals P21 and P22. The LSD 320 may receive the driver enable signal LSD_EN from the BMS 400 through the terminal P21.

The LSD 320 may generate a relay coil voltage V_LS according to the driver enable signal LSD_EN, and may transmit the relay coil voltage V_LS to the other terminal of each of the plurality of relays 210, 220, and 230 through the terminal P22.

One terminal (a high side) of each of the first relay 210, the second relay 220, and the third relay 230 may be connected to the HSD 310, and the other terminal (a low side) of each of the first relay 210, the second relay 220, and the third relay 230 may be connected to the LSD 320. The first voltage sensor 211 may be connected to one terminal of the first relay 210, the second voltage sensor 221 may be connected to one terminal of the second relay 220, and the third voltage sensor 231 may be connected to one terminal of the third relay 230.

The first voltage sensor 211 may measure a voltage of the one terminal of the first relay 210 to generate a voltage measurement signal VS1. The second voltage sensor 221 may measure a voltage of the one terminal of the second relay 220 to generate a voltage measurement signal VS2. The third voltage sensor 231 may measure a voltage of the one terminal of the third relay 230 to generate a voltage measurement signal VS3. The plurality of voltage sensors 211, 221, and 231 may transmit the generated plurality of voltage measurement signals VS1-VS3 to the BMS 400.

For example, as illustrated in FIG. 2, the relay portion 200 may include only the plurality of voltage sensors 211, 221, and 231 connected to high sides of the plurality of relays 210, 220, and 230. A voltage sensor may be connected to each of high and low sides of the plurality of relays 210, 220, and 230.

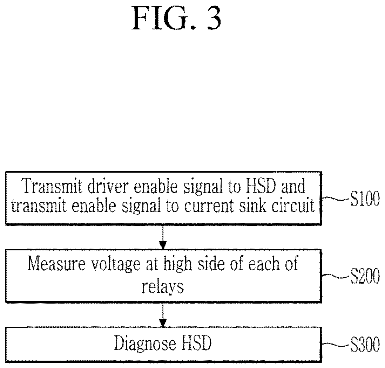

FIG. 3 is a flowchart of a diagnosis method of the HSD using the battery system according to embodiments. Hereinafter, the flowchart of FIG. 3 will be described with reference to the battery system 1 of FIG. 2.

The BMS 400 may transmit the plurality of driver enable signals to the HSD 310, and may transmit the plurality of enable signals EN1-EN3 to the plurality of current sink circuits 311-313 (S100).

The plurality of voltage sensors 211, 221, and 231 may measure a voltage at a high side of each of the plurality of relays 210, 220, and 230 (S200). The BMS 400 may receive the plurality of voltage measurement signals VS1-VS3 representing voltages measured from the plurality of voltage sensors 211, 221, and 231.

The BMS 400 may diagnose the HSD 310 based on the plurality of voltage measurement signals VS1-VS3 received from the plurality of voltage sensors 211, 221, and 231 (S300). For example, the BMS 400 may diagnose a failure mode of the HSD 310. The failure mode of the HSD 310 may include a short mode between pins caused by a short (or a short circuit) between a first pin (e.g., the terminal P11 of FIG. 2) where a first driver enable signal is input and a second pin (e.g., the terminal P12 of FIG. 2) where the second driver enable signal is input. Here, the first pin and the second pin may be pins adjacent to each other.

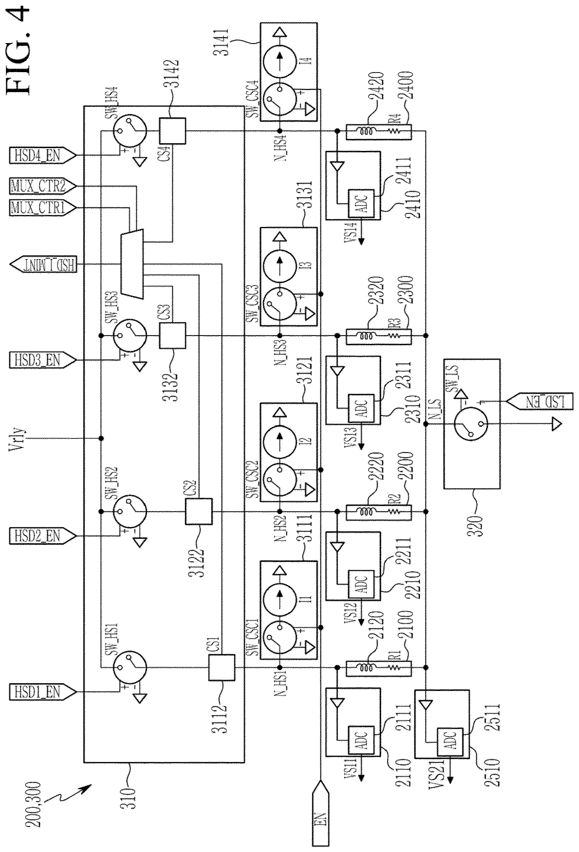

Hereinafter, a method of diagnosing the HSD 310 by the BMS 400 will be described with reference to FIGS. 4 to 7.

FIG. 4 is a circuit diagram of the relay (or the relay portion) and the relay driver of the battery system according to embodiments.

Referring to FIG. 4. the relay portion 200 may include a plurality of relays 2100, 2200, 2300, and 2400, and a plurality of voltage sensors 2110, 2210, 2310, 2410, and 2510.

Hereinafter, for convenience of description, a high side (one terminal) of the relay 2100 may be referred to as a node N_HS1, a high side (one terminal) of the relay 2200 may be referred to as a node N_HS2, a high side (one terminal) of the relay 2300 may be referred to as a node N_HS3, and a high side (one terminal) of the relay 2400 may be referred to as a node N_HS4. For example, a low side (the other terminal) of the plurality of relays 2100, 2200, 2300, and 2400 may be referred to as a node N_LS.

The relay 2100 may include a relay coil 2120 and a resistor R1. The relay 2200 may include a relay coil 2220 and a resistor R2. The relay 2300 may include a relay coil 2320 and a resistor R3. The relay 2400 may include a relay coil 2420 and a resistor R4.

The relay driver 300 may include the HSD 310, the LSD 320, and a plurality of current sink circuits 3111, 3121, 3131, and 3141.

The current sink circuit 3111 may include a switch SW_CSC1 and a current source I1. The current sink circuit 3121 may include a switch SW_CSC2 and a current source I2. The current sink circuit 3131 may include a switch SW_CSC3 and a current source I3. The current sink circuit 3141 may include a switch SW_CSC4 and a current source I4.

One terminal of each (e.g., SW_CSC1) of the plurality of switches SW_CSC1-SW_CSC4 may be connected to a high side (one terminal) of the corresponding relay (e.g., 2100) among the plurality of relays 2100, 2200, 2300, and 2400. The other terminal of each (e.g., SW_CSC1) of the plurality of switches SW_CSC1-SW_CSC4 may be connected to one terminal of the corresponding current source (e.g., I1) among the plurality of current sources I1-I4. The other terminal of each of the plurality of current sources I1-I4 may be connected to a ground.

The plurality of switches SW_CSC1_SW_CSC4 may be controlled by an enable signal EN. If the plurality of switches SW_CSC1-SW_CSC4 receives the enable signal EN of an on-level, the plurality of switches SW_CSC1-SW_CSC4 may be turned on to allow a predetermined constant current (I) to flow from each of the plurality of nodes N_HS1 to N_HS4 to the ground.

For example, as illustrated in FIG. 4, the enable signal EN may be applied to the plurality of switches SW_CSC1-SW_CSC4. In some embodiments, enable signals applied to the plurality of switches SW_CSC1 to SW_CSC4 may be different. For example, the BMS 400 may generate an enable signal that turns on only the remaining switches (e.g., SW_CSC2-SW_CSC4) except for the switch (e.g., SW_CSC1) corresponding to the relay (e.g., 2100) to which the relay driving voltage is supplied among the plurality of switches SW_CSC1-SW_CSC4 to supply the enable signal to the plurality of switches SW_CSC1-SW_CSC4.

The HSD 310 may include a plurality of switches SW_HS1-SW_HS4. The relay driving voltage Vrly may be applied to one terminal of each of the plurality of switches SW_HS1-SW_HS4. The other terminal (e.g., SW_HS1) of each plurality of switches SW_HS1-SW_HS4 may be connected to a high side (one terminal) of the corresponding relay (e.g., 2100) among the plurality of relays 2100, 2200, 2300, and 2400.

The plurality of switches SW_HS1-SW_HS4 may be controlled by a plurality of driver enable signals HSD1_EN, HSD2_EN, HSD3_EN, and HSD4_EN. The plurality of switches SW_HS1-SW_HS4 may receive the plurality of driver enable signals HSD1_EN, HSD2_EN, HSD3_EN, and HSD4_EN from the pins (e.g., the terminals P11-P13 of FIG. 2) of the HSD 310. The switch (e.g., SW_HS1) among the plurality of switches SW_HS1-SW_HS4 that receives the driver enable signal (e.g., HSD1_EN) of an on-level may be turned on to transfer the relay driving voltage Vrly to the corresponding relay (e.g., 2100) among the plurality of relays 2100, 2200, 2300, and 2400.

For example, as illustrated in FIG. 4, the relay driver 300 may include the HSD 310, the HSD 310 includes the plurality of switches SW_HS1-SW_HS4, and the plurality of switches SW_HS1-SW_HS4 are controlled by the driver enable signals HSD1_EN, HSD2_EN, HSD3_EN, and HSD4_EN. In some embodiments, the relay driver 300 may include the plurality of HSD including the switches, and the plurality of HSD may be controlled by the plurality of driver enable signals HSD1_EN, HSD2_EN, HSD3_EN, and HSD4_EN.

The LSD 320 may include a switch SW_LS. One terminal of the switch SW_LS may be connected to a low side (the other terminal) of the plurality of relays 2100, 2200, 2300, and 2400. The other terminal of the switch SW_LS may be connected to a ground.

The switch SW_LS may be controlled by the driver enable signal LSD_EN. If the switch SW_LS receives the driver enable signal LSD_EN of an on-level, the switch SW_LS may be turned on to connect the plurality of relays 2100, 2200, 2300, and 2400 to the ground.

The voltage sensor 2110 may include a buffer and an analog-digital converter (ADC) 2111. The ADC 2111 may measure a voltage of the node N_HS1 of the relay 2100, and may generate a voltage measurement signal VS11 representing the measured voltage. The voltage sensor 2210 may include a buffer and an ADC 2211. The ADC 2211 may measure a voltage of the node N_HS2 of the relay 2200, and may generate a voltage measurement signal VS12 representing the measured voltage. The voltage sensor 2310 may include a buffer and an ADC 2311. The ADC 2311 may measure a voltage of the node N_HS3 of the relay 2300, and may generate a voltage measurement signal VS13 representing the measured voltage. The voltage sensor 2410 may include a buffer and an ADC 2411. The ADC 2411 may measure a voltage of the node N_HS4 of the relay 2400, and may generate a voltage measurement signal VS14 representing the measured voltage. The voltage sensor 2510 may include a buffer and an ADC 2511. The ADC 2511 may measure a voltage of the node N_LS of the plurality of relays 2100, 2200, 2300, and 2400, and may generate a voltage measurement signal VS21 representing the measured voltage.

The plurality of analog-digital converters (ADC) 2111, 2211, 2311, 2411, and 2511 may transmit the generated plurality of voltage measurement signals VS11-VS14 and VS21 to the BMS 400. The BMS 400 may receive the plurality of voltage measurement signals VS11-VS14 and VS21, and may diagnose the HSD 310 based on the plurality of voltage measurement signals VS11-VS14 and VS21.

For example, the BMS 400 may turn on one (e.g., SW_HS1) of the plurality of switches SW_HS1-SW_HS4 and SW_LS through the plurality of driver enable signals HSD1_EN, HSD2_EN, HSD3_EN, HSD4_EN, and LSD_EN to supply the relay driving voltage Vrly to the corresponding relay (e.g., 2100) among the plurality of relays 2100, 2200, 2300, and 2400. In some embodiments, the BMS 400 may sink currents from the high sides of the plurality of relays 2100, 2200, 2300, and 2400 by driving the plurality of current sink circuits 3111, 3121, 3131, and 3141 through the enable signal EN. The BMS 400 may derive a high side voltage of each of the plurality of relays 2100, 2200, 2300, and 2400 based on the received plurality of voltage measurement signals VS11-VS14.

The BMS 400 may compare a high side voltage of the relay (e.g., 2100) that supplies the relay driving voltage Vrly with a high side voltage of the remaining relay (e.g., 2200, 2300, or 2400) among the plurality of relays 2100, 2200, 2300, and 2400 except for the relay (e.g., 2100) supplying the relay driving voltage Vrly through the plurality of driver enable signals HSD1_EN, HSD2_EN, HSD3_EN, HSD4_EN, and LSD_EN. Based on the comparison result, the BMS 400 may diagnose the HSD 310 as having a short (or a short circuit) between pins corresponding to the relay (e.g., 2200) among the remaining relays (e.g., 2200, 2300, and 2400) with the high side voltage equal to the high side voltage of the relay (e.g., 2100) supplying the relay driving voltage Vrly.

Hereinafter, voltages represented by the plurality of voltage measurement signals VS11-VS14 will be compared and described in a normal mode in which a short between pins does not occur in the HSD 310 and in the short mode between the pins in which the short between the pins occurs in the HSD 310.

For example, resistance values of R1 to R4 may be tens of ohms, currents consumed by the plurality of buffers and the plurality of analog-digital converters (ADC) 2111, 2211, 2311, 2411, and 2511 included in the plurality of voltage sensors 2110, 2210, 2310, 2410, and 2510 may be tens of microamps, and voltage drops across the plurality of voltage sensors 2110, 2210, 2310, 2410, and 2510 may be hundreds of microvolts. Thus, it is assumed that they are very small so that they are omitted in calculation.

In some embodiments, a predetermined constant current (I(A)) represented by each of the plurality of current sources I1-I4 may be determined to be less than a relay pickup current (e.g., 0.25A).

A case in which only the switch SW_HS1 is turned on, the remaining switches SW_HS2-SW_HS4 are turned off, and the plurality of switches SW_CSC1-SW_CSC4 are turned on will be described. The BMS 400 may generate the driver enable signal HSD1_EN of the on-level and the enable signal EN of the on-level to transmit them to the relay driver 300.

First, because the short between the pins does not occur in the normal mode, the voltage of the node N_HS1 indicated by the voltage measurement signal VS11 may be the relay driving voltage Vrly. A current of 3 *I(A) may flow from the node N_HS1 to the node N-LS according to the current sink operation that allows a current of each of the plurality of current sources I2-I4 to flow to the ground. For example, a voltage drop of 3*R1*I(V) may occur between the node N_HS1 and the node N-LS due to the resistor R1. In some embodiments, a voltage of the node N_LS represented by the voltage measurement signal VS21 may be Vrly-3*R1*I(V).

A current of I(A) may flow from the node N_LS to the node N_HS2 according to the current sink operation of the current source I2. For example, a voltage drop of R2*I(V) may occur from the node N_LS to the node N_HS2 by the resistor R2. In some embodiments, a voltage of the node N_HS2 represented by the voltage measurement signal VS12 may be Vrly-(3*R1+R2)*I(V).

A current of I(A) may flow from the node N_LS to the node N_HS3 according to the current sink operation of the current source I3. For example, a voltage drop of R3*I(V) may occur from the node N_LS to the node N_HS3 by the resistor R3. In some embodiments, a voltage of the node N_HS3 indicated by the voltage measurement signal VS13 may be Vrly-(3*R1+R3)*I(V).

A current of I(A) may flow from the node N_LS to the node N_HS4 according to the current sink operation of the current source I4. For example, a voltage drop of R4*I(V) may occur from the node N_LS to the node N_HS4 by the resistor R4. In some embodiments, a voltage of the node N_HS4 represented by the voltage measurement signal VS14 may be Vrly-(3*R1+R4)*I(V).

Next, it is assumed that in the short mode, a short occurs between the first pin (the terminal P11 of the FIG. 2) for supplying the driver enable signal HSD1_EN to the switch SW_HS1 and the second pin (the terminal P12 of FIG. 2) for applying the driver enable signal HSD2_EN to the switch SW_HS2.

For example, the switch SW_HS1 may be turned on so that the voltage of the node N_HS1 indicated by the voltage measurement signal VS11 is the relay driving voltage Vrly. In some embodiments, the switch SW_HS2 may also be turned on due to the short between the pins so that the relay driving voltage Vrly is applied to the node N_HS2. Thus, the voltage of the node N_HS2 indicated by the voltage measurement signal VS12 may also be the relay driving voltage Vrly(V).

For example, in the normal mode, there may be a difference between the voltage of the node N_HS1 and the voltage of the node N_HS2, but in the short mode, the voltage of the node N_HS1 and the voltage of the node N_HS2 may be the same.

The BMS 400 may receive the plurality of voltage measurement signals VS11-VS14 and VS21 to monitor voltages of the plurality of nodes N_HS1-N_HS4 and N_LS. The BMS 400 may determine whether the voltage of each of the plurality of nodes N_HS1-N_HS4 and N_LS is out of a predetermined voltage range based on the voltage in the normal mode of each of the plurality of nodes N_HS1-N_HS4 and N_LS. If a voltage outside the predetermined voltage range is detected (or sensed) from the node corresponding to the remaining switch except for the turned-on switch SW_HS1 among the plurality of switches SW_HS1-SW_HS4 of the HSD 310, the BMS 400 may determine that a short (or a short circuit) occurs in a pin corresponding to the node representing the detected voltage.

In the above example, the BMS 400 may detect whether the voltage of the node N_HS2 is out of the predetermined voltage range based on the voltage Vrly-(3*R1+R2)*I(V) in the normal mode. If the voltage of the node corresponding to the remaining switch except for the turned-on switch SW_HS1 among the plurality of switches SW_HS1-SW_HS4 is the relay driving voltage Vrly(V), the BMS 400 may determine in advance that the voltage of the node N_HS2 is out of the predetermined voltage range. Because the voltage of the node N_HS2 is the relay driving voltage Vrly(V), the BMS 400 may determine that a short occurs in a pin corresponding to the node N_HS2.

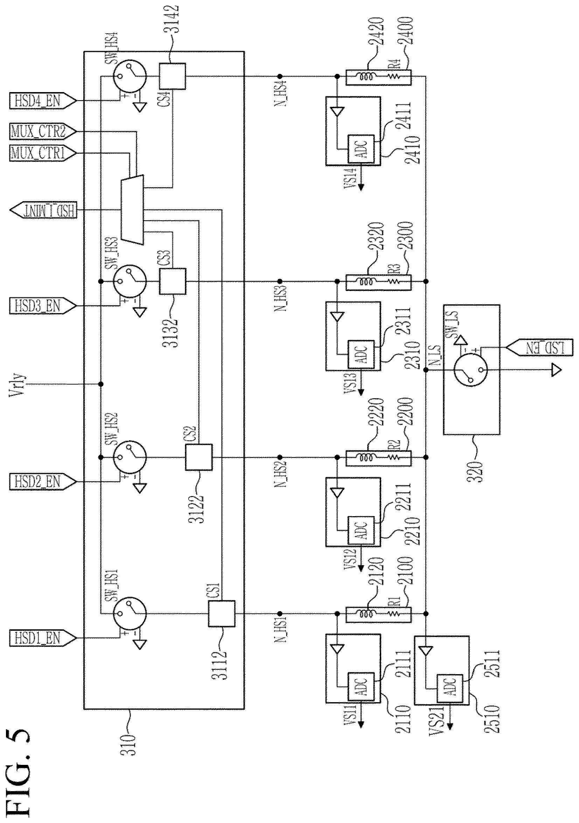

FIG. 5 is an exemplary diagram of a comparative circuit excluding the plurality of current sink circuits from the circuit diagram of FIG. 4.

It is assumed that s current flowing from the node N_HS1 to the ADC 2111, a current flowing from the node N_HS2 to the ADC 2211, a current flowing from the node N_HS3 to the ADC 2311, and a current flowing from the node N_HS4 to the ADC 2411 are Ia(A).

It is assumed that in the compared circuit, the current (Ia(A)) is tens of microamps and voltage drops due to the plurality of voltage sensors 2110, 2210, 2310, 2410, and 2510 are hundreds of microvolts so that they are very small.

In the normal mode, a voltage of the node N_HS1 indicated by the voltage measurement signal VS11 may be the relay driving voltage Vrly. A voltage of the node N_HS2 represented by the voltage measurement signal VS12 may be Vrly-(3*R1+R2)*Ia(V). A voltage of the node N_HS3 represented by the voltage measurement signal VS13 may be Vrly-(3*R1+R3)*Ia(V). A voltage of the node N_HS4 represented by the voltage measurement signal VS14 may be Vrly-(3*R1+R4)*Ia(V).

However, because a voltage drop due to Ia is very small compared with a voltage drop caused by I of the embodiments so that it is difficult to detect the voltage drop due to Ia and it is impossible to detect the voltage drop due to Ia at a level of 1.2mV/bit that is a general resolution of the ADC, all voltages of the nodes N_HS1-N_HS4 may be output as Vrly(V). Because in the comparative circuit, a difference between the voltages of the nodes N_HS1-N_HS4 in the normal mode is not large and a difference between the voltages in the normal mode and the voltages in the short mode is small, it is difficult for the compared circuit to detect a voltage change in the short mode compared with the embodiments of the present disclosure.

For example, in embodiments, the plurality of current sink circuits may be provided to amplify a voltage change in the normal mode and a voltage change in the short mode so that the HSD 310 is diagnosed.

Referring to FIG. 4 and FIG. 5, the HSD 310 may further include a plurality of current sensors 3112, 3122, 3132, and 3142 and a MUX (or a multiplexer). Each (e.g., 3112) of the plurality of current sensors 3112, 3122, 3132, and 3142 may be connected at a wire between one (e.g., SW_HS1) of the plurality of switches SW_HS1-SW_HS4 and the corresponding relay (e.g., 2100) of the plurality of relays 2100, 2200, 2300, and 2400.

The current sensor 3112 may measure a current between the other terminal of the switch SW_HS1 and one terminal of the relay 2100, and may generate a current measurement signal CS1 representing the measured current. The current sensor 3122 may measure a current between the other terminal of the switch SW_HS2 and one terminal of the relay 2200, and may generate a current measurement signal CS2 representing the measured current. The current sensor 3132 may measure a current between the other terminal of the switch SW_HS3 and one terminal of the relay 2300, and may generate a current measurement signal CS3 representing the measured current. The current sensor 3142 may measure a current between the other terminal of the switch SW_HS4 and one terminal of the relay 2400, and may generate a current measurement signal CS4 representing the measured current.

The plurality of current sensors 3112, 3122, 3132, and 3142 may transmit the generated plurality of current measurement signals CS1-CS4 to the MUX. An operation of the MUX may be controlled according to a plurality of MUX control signals MUX_CTR1 and MUX_CTR2. The MUX may generate a current monitoring signal HSD_I_MNT representing one of the plurality of current measurement signals CS1-CS4 according to the plurality of MUX control signals MUX_CTR1 and MUX_CTR2. The MUX may transmit the current monitoring signal HSD_I_MNT to the BMS 400. The BMS 400 may receive the plurality of voltage measurement signals VS11-VS14 and VS21 and/or the current monitoring signal HSD_I_MNT, and may diagnose the HSD 310 based thereon.

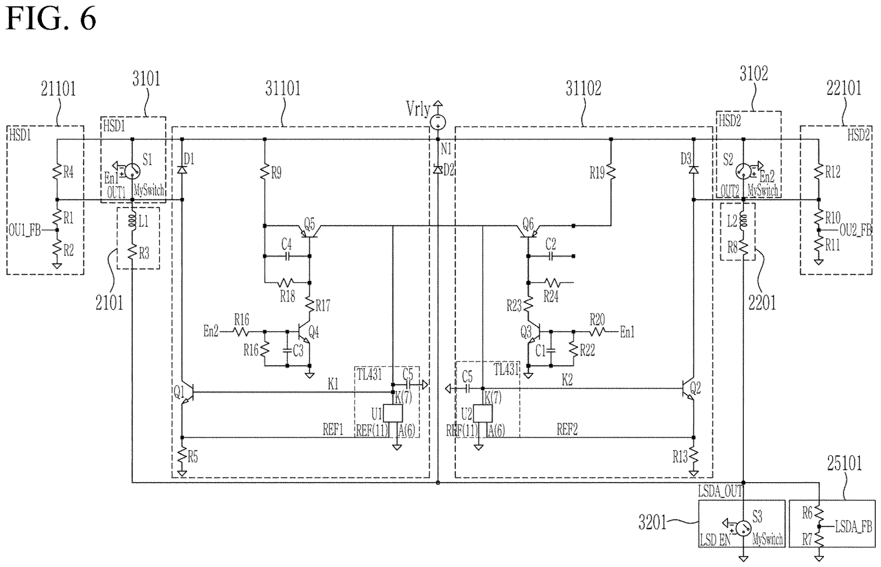

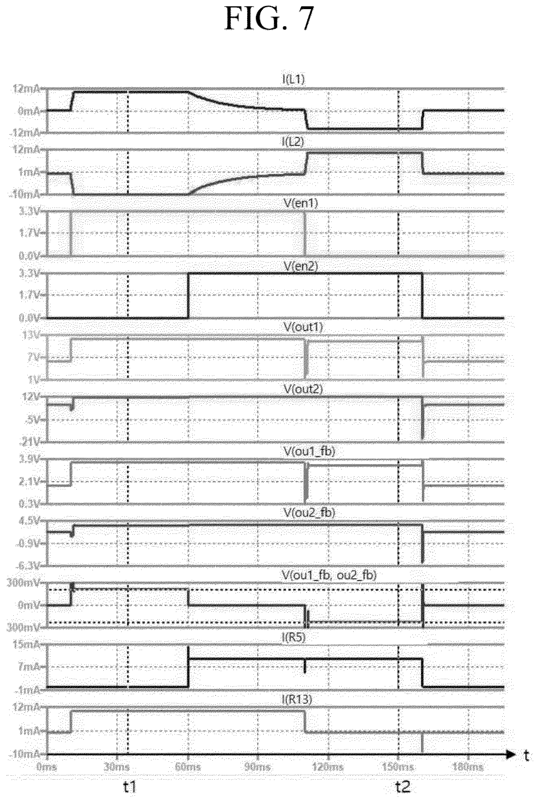

Hereinafter, a waveform of a voltage monitored in the battery system according to embodiments will be described with reference to FIGS. 6 and 7.

FIG. 6 is an exemplary diagram of a two-channel relay and a two-channel relay driver.

The relay portion 200 may include a relay 2101, a relay 2201, a voltage sensor 21101, a voltage sensor 22101, and a voltage sensor 25101. The voltage sensor 21101 may monitor a voltage of a high side (one terminal) of the relay 2101, the voltage sensor 22101 may monitor a voltage of a high side (one terminal) of the relay 2201, and the voltage sensor 25101 may monitor a voltage of a low side (the other terminal) of the relay 2101 and a voltage of a low side (the other terminal) of the relay 2201.

The relay driver 300 may include a first HSD 3101, a second HSD 3102, an LSD 3201, a current sink circuit 31101, and a current sink circuit 31102. The relay driving voltage Vrly may be supplied to the first HSD 3101 and the second HSD 3102.

The current sink circuit 31101 may be connected to a node between the first HSD 3101 and a node N1 to which the relay driving voltage Vrly is applied, and may operate as a current sink by an enable signal En2. The current sink circuit 31102 may be connected to a node between the second HSD 3102 and the node N1 to which the relay driving voltage Vrly is applied, and may operate as a current sink by an enable signal En1.

An operation of the first HSD 3101 may be controlled by the enable signal En1, and an operation of the second HSD 3102 may be controlled by the enable signal En2.

If the enable signal En1 of an on-level is generated from the BMS 400 to be supplied to the first HSD 3101 and the current sink circuit 31102, a switch S1 of the first HSD 3101 may be turned on so that a current is supplied to a coil L1 of the relay 2101 according to the relay driving voltage Vrly. For example, the current sink circuit 31102 may operate as a current sink so that a current flowing from the node N1 to the second HSD 3102 flows to a ground.

If the enable signal En2 of an on-level is generated from the BMS 400 to be supplied to the second HSD 3102 and the current sink circuit 31101, a switch S2 of the second HSD 3102 may be turned on so that a current is supplied to the coil L2 of the relay 2201 according to the relay driving voltage Vrly. In some embodiments, the current sink circuit 31101 may operate as a current sink so that a current flowing from the node N1 to the first HSD 3101 flows to the ground.

FIG. 7 is a waveform diagram of a voltage monitored through the circuit of FIG. 6.

In FIG. 7, it is assumed that currents (I) sinking in the current sink circuits 31101 and 31102 are 10 mA. I(L1) may represent a current of the coil L1 included in the relay 2101 of FIG. 6, and I(L2) may represent a current of a coil L2 included in the relay 2201 of FIG. 6. V(en1) may represent the enable signal En1 driving the first HSD 3101 and the current sink circuit 31102, and V(en2) may represent the enable signal En2 driving the second HSD 3102 and the current sink circuit 31101.

V(out1) may represent a voltage of a high side (one terminal) of the relay 2101, and V(out2) may represent a voltage of a high side (one terminal) of the relay 2201. V(ou1_fb) may be a feedback voltage represented by a voltage measurement signal (OU1_FB) generated by the voltage sensor 21101, and may represent a value corresponding to the voltage V(out1), and V(ou2_fb) may be a feedback voltage represented by a voltage measurement signal (OU2_FB) generated by the voltage sensor 22101, and may represent a value corresponding to the voltage V(out2). V(ou1_fb, ou2_fb) may represent a difference obtained by subtracting the voltage V(ou2_fb) from the voltage V(ou1_fb).

I(R5) may represent a current flowing to a resistor R5 included in the current sink circuit 31101, and I(R13) may represent a current flowing to a resistor R13 included in the current sink circuit 31102.

Referring to FIG. 7, V(ou1_fb, ou2_fb) may indicate 218.93409 mV at a time (t1(34.375 ms)) when V(en1) is at a high level and V(en2) is at a low level. For example, V(ou1_fb, ou2_fb) may indicate -220.57152 mV at a time (t2(150 ms)) when V(en1) is at a low level and V(en2) is at a high level.

In some embodiments, because an amount of change of a voltage monitored according to on/off of the first HSD 3101 and on/off of the second HSD 3102 indicates about 220 mV, 220 mV may be detected as a change of about 180 bits. In some embodiments, it is possible to detect the change of the voltage even at the level of 1.2mV/bit that is the general resolution of the ADC included in the voltage sensor.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A battery system, comprising:
a battery pack;
a plurality of relays connected to the battery pack;
a relay driver configured to drive commonly a low side of the plurality of relays and drive each of the plurality of relays at a high side of each of the plurality of relays; and
a battery management system configured to control an operation of the relay driver, receive a voltage measured from one terminal of each of the plurality of relays, and diagnose the relay driver based on the received voltage.

2. The battery system as claimed in claim 1, wherein the relay driver includes:
a high-side driver configured to supply a relay driving voltage to a high side of a relay corresponding to a first signal among the plurality of relays based on the first signal received from the battery management system;
a low-side driver configured to connect the low side of the plurality of relays to a ground based on a second signal received from the battery management system; and
a plurality of current sink circuits configured to sink a current from a node between the high-side driver and a high side of a relay corresponding to a third signal among the plurality of relays based on the third signal received from the battery management system.

3. The battery system as claimed in claim 2, wherein the high-side driver includes a plurality of switches connected between the relay driving voltage and the plurality of relays, and each of the plurality of switches are configured to receive a control signal from a pin.

4. The battery system as claimed in claim 2 or 3, further comprising a plurality of voltage sensors configured to transmit voltage measurement signals generated by measuring voltages from high sides of the plurality of relays to the battery management system.

5. The battery system as claimed in claim 4, wherein the battery management system is further configured to supply the relay driving voltage to one relay of the plurality of relays, drive the plurality of current sink circuits, and receive the voltage measurement signals from the plurality of voltage sensors.

6. The battery system as claimed in claim 5, wherein the battery management system is further configured to derive a voltage of a high side of the one relay and a voltage of a high side of each of the remaining at least one relay other than the one relay among the plurality of relays based on the voltage measurement signals, and determine that a short between high side pins connected to a relay among the remaining at least one relay having a voltage of a high side equal to the voltage of the high side of the one relay occurs.

7. A diagnosis method, comprising:
commonly driving, by a relay driver, a low side of a plurality of relays connected to a battery pack and driving, by the relay driver, each of the plurality of relays at a high side of each of the plurality of relays;
measuring a voltage from one terminal of each of the plurality of relays; and
diagnosing the relay driver based on the measured voltage.

8. The diagnosis method as claimed in claim 7, wherein the driving of each of the plurality of relays includes:
supplying, by a high-side driver, a relay driving voltage to a high side of a relay corresponding to a first signal among the plurality of relays based on the first signal received from a battery management system
connecting, by a low-side driver, the low side of the plurality of relays to a ground based on a second signal received from the battery management system; and
sinking, by a plurality of current sink circuits, a current from a node between the high-side driver and a high side of a relay corresponding to a third signal among the plurality of relays based on the third signal received from the battery management system.

9. The diagnosis method as claimed in claim 8, wherein supplying the relay driving voltage to the high side of the relay includes applying, by the battery management system, control signals to a plurality of switches connected between the relay driving voltage and the plurality of relays through a plurality of pins of the high-side driver to turning on the plurality of switches.

10. The diagnosis method as claimed in claim 8 or 9, wherein measuring the voltage from the one terminal of each of the plurality of relays includes:
generating voltage measurement signals by measuring voltages from high sides of the plurality of relays; and
transmitting the generated voltage measurement signals to the battery management system.

11. The diagnosis method as claimed in claim 8, 9, or 10, further comprising:
generating, by the battery management system, a signal supplying the relay driving voltage to one relay of the plurality of relays to transmit the generated signal to the high-side driver;
generating, by the battery management system, a signal driving the plurality of current sink circuits to transmit the generated signal to the current sink circuits; and
receiving, by the battery management system, a voltage measurement signal representing a voltage measured from the high side of each of the plurality of relays.

12. The diagnosis method as claimed in claim 11, further comprising:
deriving a voltage of a high side of the one relay and a voltage of a high side of each of the remaining at least one relay other than the one relay among the plurality of relays based on the voltage measurement signal; and
determining that a short between high side pins connected to a relay among the remaining at least one relay having a voltage of a high side equal to the voltage of the high side of the one relay occurs.
